Europäisches Patentamt

European Patent Office

Office européen des brevets

(11) Veröffentlichungsnummer: 0 353 719
A2

## (12) EUROPÄISCHE PATENTANMELDUNG

(21) Anmeldenummer: 89114213.5

(51) Int. Cl.⁴: H01L 21/321 , H01L 21/28

(22) Anmeldetag: 01.08.89

(30) Priorität: 05.08.88 DE 3826733

(43) Veröffentlichungstag der Anmeldung:
07.02.90 Patentblatt 90/06

(84) Benannte Vertragsstaaten:
DE FR GB NL

(71) Anmelder: Siemens Aktiengesellschaft
Wittelsbacherplatz 2
D-8000 München 2(DE)

(72) Erfinder: Pausch, Thomas, Dipl.-Phys.
Seilerbrücklstrasse 20a
D-8050 Freising(DE)
Erfinder: Willer, Josef, Dr.
Hirschplanallee 3
D-8042 Oberschleissheim(DE)

(54) Metallkontakt mit überhängenden Kanten und Herstellungsverfahren.

(57) Metallkontakt mit überhängenden Kanten auf einer Halbleiterschichtstruktur, wobei dieser Metallkontakt mindestens eine spezielle Metallschicht (3), die einheitlich zusammengesetzt ist und sich in Richtung auf die Oberfläche der Halbleiterschichtstruktur (9) auf dem Substrat (10) hin stetig verjüngt, vorgesehen ist. Dieser Metallkontakt wird hergestellt, indem bei dem Ätzschritt für die Herstellung der speziellen Metallschicht (3) mittels Ätzmaske (8) und Anwendung von RIE ein Verhältnis von Anodendurchmesser zu Kathodendurchmesser von mindestens 4:3 eingestellt wird und der Elektrodenabstand mindestens 4 cm beträgt.

## FIG 3

EP 0 353 719 A2

## Metallkontakt mit überhängenden Kanten und Herstellungsverfahren

Die Verkleinerung von Bauelementen ist in den letzten Jahrzehnten wegen der Möglichkeit, hohe Integrationsdichten sowie hohe Schaltgeschwindigkeiten zu erreichen, von herausragender Bedeutung für die Halbleitertechnologie geworden. Bei der Verwirklichung von Geometrien unterhalb 1 μm stößt man auf zunehmende Schwierigkeiten bei lichtoptischen Fototechniken. Abhilfe bringen hier selbstjustierende Prozesse, bei denen z.B. beim MESFET die Gatemetallisierung in bezug auf nachfolgende Prozeßschritte, z.B. n$^+$-Implantationen und/oder Source-/Drainkontakte als Maske wirkt.

Bei solchen selbstjustierenden Prozessen werden in der Regel nach dem Aufbringen der Gatemetallisierung weitere Temperschritte durchgeführt. Es ist daher erforderlich, daß die Metallisierung gegenüber solchen Temperprozessen hinreichend stabil ist. Andererseits erreicht man mit diesen Verfahren elektrisch wirksame Gatelängen unterhalb 1 μm. Trotzdem lassen sich kleine Zuleitungswiderstände durch hinreichend große Gatequerschnitte realisieren. Zu dem Zweck gestaltet man die Metallkontakte mit überhängenden Kanten.

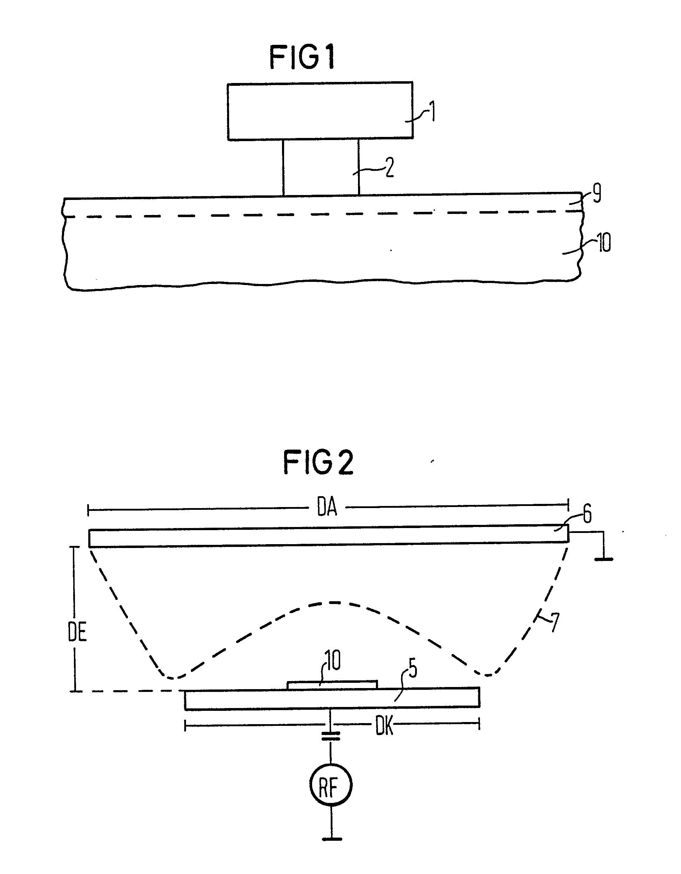

Bisher wurden im wesentlichen Gatemetallisierungen mit T-förmiger Struktur erzeugt, z.B. durch einen Trockenätzprozeß. Für die Herstellung solcher überhängender Metallisierungen sind mindestens zwei Schichten aus verschiedenen Metallen erforderlich. Als Ätzmaske kann Fotolack oder eine in Lift-off-Technik abgeschiedene dritte Metallstruktur dienen. Es können nicht beliebige Metalle verwendet werden; wegen des erforderlichen selektiven Ätzens werden vielmehr an die Wahl der Metalle zusätzliche Anforderungen gestellt. Es muß möglich sein, die erste abgeschiedene Metallschicht beim Ätzen stärker anzugreifen, als die darüber befindliche zweite Metallschicht. Den Aufbau, den man auf diese Weise erhält, zeigt Fig. 1. Es ist dort das Substrat 10 dargestellt mit einer durch eine gestrichelte Linie angedeuteten Halbleiterschichtstruktur 9. Die erste Metallschicht 1 und die zweite Metallschicht 2 liefern einen stufenförmigen, also unstetigen Querschnitt der Gatemetallisierung. Ein solcher Aufbau wird z.B. hergestellt, indem zunächst eine Ätzmaske aufgebracht wird und dann mittels anisotropen Ätzens die beiden Metallschichten bis auf die Halbleiteroberfläche geradlinig herabgeätzt werden. Hohe Anisotropie bei der Ätzung erhält man, indem der Druck des Plasmas während des Trockenätzprozesses niedrig gehalten wird und die Kathodenspannung hoch eingestellt wird. Nachdem die beiden Metallschichten mit auf der Oberfläche der Halbleiterschichtstruktur 9 senkrechtstehenden seitlichen Begrenzungen herausgeätzt sind, erhöht man den Ätzangriff auf die zweite Metallschicht 2 erheblich, was z.B. durch eine Änderung der Gaszusammensetzung und/oder Erhöhung des Prozeßdruckes erreicht wird. In der Regel geschieht dies durch einen oberflächenschonenden isotropen Ätzprozeß, der bei einer niedrigen Leistungsdichte abläuft. Die Größe der Unterätzung wird dabei über die Ätzzeit festgelegt. Ein Endpunktsignal wie es z.B. beim Durchätzen von einer bestimmten Schicht zu einer anderen detektiert werden kann (z.B. Änderung der optischen Eigenschaften des Plasmas) steht hierbei nicht zur Verfügung. Dies schränkt in der Praxis die Genauigkeit und Reproduzierbarkeit der Unterätzung ein. Es ergibt sich so die in der Fig. 1 dargestellte Struktur, wobei die seitliche begrenzende Oberfläche der zweiten Metallschicht 2 ebenfalls senkrecht auf der Oberfläche der Halbleiterschichtstruktur 9 steht und in dieser senkrechten Richtung geradlinig verläuft.

Vor der Anode der RIE-Anlage bildet sich beim Ätzvorgang im Plasma die sogenannte positive Säule, in der das Potential konstant ist, aus; diese positive Säule reicht bis fast vor die Kathode. Vor der Kathode befindet sich die Dunkelfeldzone, die von der positven Säule durch eine Äquipotentialfläche begrenzt ist, die nahezu parallel zur Oberfläche der Kathode und des Substrates verläuft.

Aufgabe der vorliegenden Erfindung ist es, für ein Halbleiterbauelement eine Metallisierung mit überhängenden Kanten, d.h. eine Metallisierung, die sich zur Oberfläche des Halbleitermaterials hin verjüngt, ein Herstellungsverfahren und eine Vorrichtung zur Durchführung dieses Herstellungsverfahrens anzugeben.

Diese Aufgabe wird mit dem Metallkontakt mit den Merkmalen des Anspruchs 1, mit dem Herstellungsverfahren mit den Merkmalen nach Anspruch 4 bzw. mit der Vorrichtung mit den Merkmalen des Anspruchs 6 gelöst.

Die Beschreibung stützt sich auf die Figuren 1 bis 4.

Fig. 1 zeigt einen Metallkontakt mit überhängenden Kanten nach dem Stand der Technik.

Fig. 2 zeigt die wesentlichen Komponenten einer RIE-Vorrichtung.

Fig. 3 zeigt einen erfindungsgemäßen Metallkontakt mit darauf befindlicher Ätzmaske.

Fig. 4 zeigt einen mehrlagigen erfindungsgemäßen Metallkontakt mit darauf befindlicher Ätzmaske.

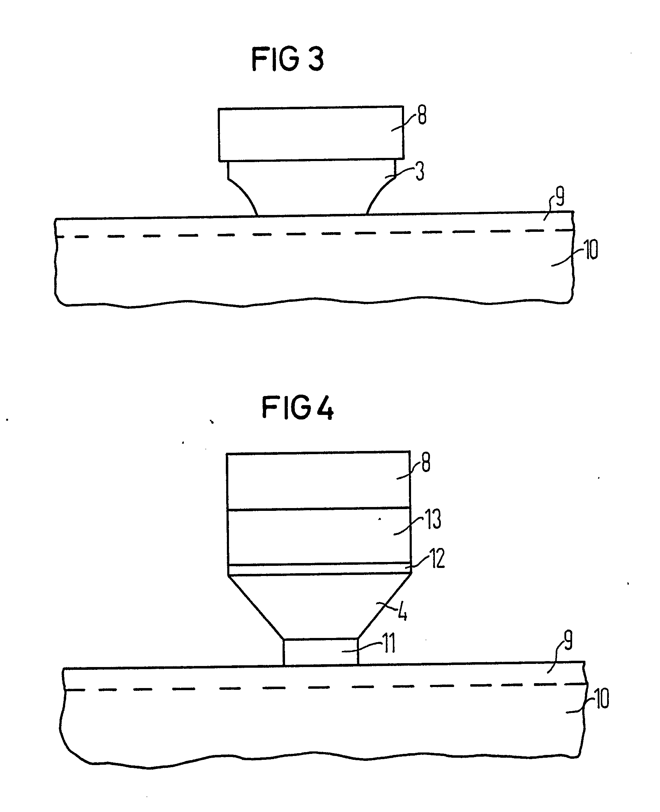

Statt wie im Stand der Technik (Fig. 1) die überhängenden Kanten des Metallkontaktes dadurch zu erzeugen, daß eine zweite Metallschicht 2 und darauf eine über diese zweite Metallschicht 2 überhängende erste Metallschicht 1 aufgebracht werden, besitzt der erfindungsgemäße Metallkontakt eine spezielle Metallschicht 3 (Fig. 3), die in sich einheitlich, bestehend aus z.B. nur einem Metall, aufgebaut ist und sich zum Substrat 10 hin verjüngt. In der Fig. 3 ist das Substrat 10 mit der darauf befindlichen Halbleiterschichtstruktur 9 und der den Metallkontakt bildenden speziellen Metallschicht 3 mit einer darauf befindlichen, bei der Herstellung verwendeten Ätzmaske 8 dargestellt. Diese spezielle Metallschicht 3 ist über den eigentlichen Kontakt zwischen Metall und Halbleitermaterial ausladend ausgebildet. Auf diese Weise ergeben sich erfindungsgemäß die überhängenden oberen Kanten des Metallkontaktes, ohne daß hierfür mindestens zwei verschiedene Metallschichten, die zu dem aus verschiedenen Metallen bestehen, erforderlich sind. Die vorliegende Erfindung betrifft genausogut spezielle Metallschichten 3, die nur aus einem einzigen Metall bestehen, wie solche, die aus verschiedenen Elementen zusammengesetzt sind, z.B. Legierungen. Wesentlich ist, daß diese spezielle Metallschicht 3 eine einheitliche Zusammensetzung besitzt in dem Sinne, daß keine voneinander abgegrenzten Metallschichten vorhanden sind. Das schließt nicht aus, daß, wie in Fig. 4 dargestellt, eine erfindungsgemäße spezielle Metallschicht 4 zur Ausbildung überhängender Kanten nicht unmittelbar auf der Halbleiterschichtstruktur 9 aufgebracht ist, sondern der Metall-Halbleiter-Kontakt durch eine erste weitere Metallschicht 11 gebildet wird, auf der besagte spezielle Metallschicht 4 aufgebracht ist, und weitere Metallschichten - in der Figur eine zweite weitere Metallschicht 12 und eine dritte weitere Metallschicht 13 - auf die spezielle Metallschicht 4 folgen.

Die erfindungsgemäße spezielle Metallschicht 3, 4, die die über die Kontaktfläche überhängenden Metallkanten aufweist, verjüngt sich zum Substrat hin stetig. Das ist ein Unterschied zum Stand der Technik mit dem in Fig. 1 dargestellten sprunghaften Übergang zwischen den Metallschichten 1, 2. Diese Verjüngung braucht nicht streng monoton zu erfolgen; in Fig. 3 weist die spezielle Metallschicht 3 in ihrem oberen Bereich relativ zur Oberfläche der Halbleiterschichtstruktur 9 senkrecht verlaufende seitliche Begrenzungen auf und verjüngt sich in ihrem unteren Teil zum Substrat 10 hin degressiv. Die in Fig. 4 dargestellte spezielle Metallschicht 4 weist demgegenüber einen Querschnitt mit linearen Begrenzungen auf. Ebenso gehört zur Erfindung, daß der dem Substrat 10 zugewandte Teil der speziellen Metallschicht senkrechte Begrenzungen aufweist oder daß Teile des sich verjüngenden Bereiches eine progressive Abnahme des Durchmessers besitzen.

Da im Gegensatz zum Stand der Technik der isotrope Unterätzschritt nicht erforderlich ist, entfällt die Ungenauigkeit der Linienbreitenkontrolle bei fehlendem Endpunktsignal. Stattdessen wird die Linienbreite über die Verjüngung festgelegt und zwar über einen Ätzschritt, dessen Endpunkt exakt detektiert werden kann. Dies kommt in erster Linie der Genauigkeit zugute.

Es folgt die Beschreibung eines Verfahrens zur Herstellung eines erfindungsgemäßen Metallkontaktes und einer Vorrichtung zur Anwendung dieses Verfahrens. Das Verfahren besteht darin, daß beim RIE-Prozeß die vor der Anode 6 (vergleiche Fig. 2) befindliche positive Säule keine parallel zur Kathode 5 und im wesentlichen parallel zu dem darauf aufgebrachten Substrat 10 verlaufende Begrenzung 7 durch eine Äquipotenitalfläche aufweist, sondern daß diese Äquipotentialfläche 7 über der Kathode 5 konkav zu der Kathode 5 hin gewölbt ist. über dem Substrat 10 besitzt die Dunkelfeldzone dann eine wesentlich größere Ausdehnung als sonst üblich. Einen solchen Verlauf der Grenze 7 der positiven Säule erreicht man, indem man das Verhältnis von Anodendurchmesser DA zu Kathodendurchmesser DK größer als 4:3 wählt. Mit Durchmesser ist hierbei bei kreisförmigen Elektroden tatsächlich der Durchmesser, im übrigen die für die Größe der Elektrodenfläche typische Abmessung gemeint. Nach experimentellem Befund ergibt sich für einen Elektrodenabstand DE größer als ca. 4 cm und bei Prozeßdrücken unterhalb 10 $\mu$bar und Leistungsdichten größer als 0,5 Watt/cm$^2$ der für das erfindungsgemäße Verfahren erforderliche Verlauf der Grenze 7 der positiven Säule. Das Metall, das zur Ausbildung der speziellen Metallschicht 3, 4 aufgebracht worden ist, kann z.B. WSi$_x$ und das Ätzgas SF$_6$ sein.

In einer Weiterführung der Erfindung kann das zu ätzende Metall auch aus mehreren Lagen bestehen, z.B. WSi$_x$, W, TiN und Au. Durch selektive Ätzung der verschiedenen Metallschichten erhält man die in Fig. 4 angegebene Struktur, bei der die spezielle Metallschicht 4 aus Wolfram, die erste weitere Metallschicht 11 aus WSi$_x$, die zweite weitere Metallschicht 12 aus TiN und die dritte weitere Metallschicht 13 aus Gold besteht. Diese Aufbauung hat niedrigen elektrischen Widerstand, bondbare Gold-Deckschicht und eine TiN-Schicht als Diffusionsbarriere. Durch die erfindungsgemäße Ausgestaltung der speziellen Metallschicht 4 erhält man z.B. bei einem Feldeffekttransistor Gate metallisierungen im Submikrometerbereich für die Anwendung im Zuge selbstjustierender Prozesse.

**Ansprüche**

1. Verfahren zur Herstellung eines Metallkontaktes mit überhängenden Kanten auf einer Halbleiterschichtstruktur (9) auf einem Substrat (10), wobei in diesem Metallkontakt mindestens eine spezielle Metallschicht (3,4), die sich in Richtung auf die Oberfläche der Halbleiterschichtstruktur (9) hin verjüngt und die einheitlich zusammengesetzt ist, ausgebildet ist und durch die Verjüngung dieser speziellen Metallschicht (3,4) das Überhängen der oberen Kanten des Metallkontakts bewirkt ist,

**dadurch gekennzeichnet,**

- daß dieses Verfahren die Anwendung von Reaktivem Ionenätzen (RIE) und Maskentechnik einschließt und

- daß bei dem Ätzschritt die Äquipotentialfläche, die die Grenze (7) zwischen positiver Säule und Dunkelfeldzone bildet, zum auf der Kathode (5) angebrachten Substrat (10) hin konkav gekrümmt ist.

2. Verfahren nach Anspruch 1,

**dadurch gekennzeichnet,**

daß der Prozeßdruck höchstens 10 µbar und daß die Leistungsdichte mindestens 0,5 W/cm$^2$ beträgt.

3. Vorrichtung zur Durchführung des Verfahrens nach Anspruch 1 oder 2 mit den für die Durchführung von Trockenätzprozessen erforderlichen Bestandteilen, insbesondere einer Kathode mit einer Fläche zur Aufnahme von Substraten und einer Anode und zugehöriger Spannungsversorgung,

**dadurch gekennzeichnet,**

daß der Abstand von Kathode (5) und Anode (6) mindestens 4 cm beträgt und daß die für die Größen der effektiven Flächen von Kathoden (5) und Anode (6) bestimmenden Abmessungen in einem Verhältnis von höchstens 3:4 stehen.

4. Vorrichtung nach Anspruch 3,

**dadurch gekennzeichnet,**

daß die effektiven Flächen von Kathode (5) und Anode (6) kreisförmig sind und die deren Größen bestimmenden Abmessungen die Durchmesser sind.

# FIG 1

# FIG 2

## FIG 3

## FIG 4